# EUROPEAN PATENT SPECIFICATION

(11) **EP 0 286 289 B1**
(45) Date of publication and mention of the grant of the patent: **14.05.1997**
(21) Application number: 88302739.3
(22) Date of filing: 28.03.1988
(51) Int. Cl.: H01L 39/14, H01L 39/24

(54) **A method of preparing a superconducting oxide and superconducting oxide metal composites**
Verfahren zur Herstellung von supraleitenden Oxiden und Oxid-Metall-Verbundwerkstoffen
Procédé de fabrication des oxydes et composites oxyde-métal supraconducteurs

(30) Priority: 27.03.1987 US 31407; 10.06.1987 US 61233
(43) Date of publication of application: 12.10.1988
(60) Divisional application: 96101288.7
(73) Proprietor: MASSACHUSETTS INSTITUTE OF TECHNOLOGY, Cambridge, MA 02139 (US)
(72) Inventor: Yurek, Gregory J., Wellesley Massachusetts 02181 (US); VanderSande, John B., Newbury Massachusetts 01951 (US)
(74) Representative: Beetz & Partner Patentanwälte

(56) References cited:
- EP-A- 0 282 286
- EP-A- 0 282 839
- EP-A- 0 283 024
- DE-A- 2 516 747
- JAPANESE JOURNAL OF APPLIED PHYSICS, vol. 26, no. 4, April 1987, pages L334- L336; K. MATSUZAKI et al.: "Preparation of a high Tc superconductor by oxidization of an amorphous La1.8Sr0.2Cu alloy ribbon in air"
- PHYSICAL REVIEW LETTERS, vol. 58, no. 4, 26th January 1987, pages 405-407, The American Physical Society; C.W. CHU et al.: "Evidence for superconductivity above 40 K in the La-Ba-Cu-O compound system"

## Description

Superconductors are materials having essentially zero resistance to the flow of electrons below a certain critical temperature, T_{c}. It is known that certain metal oxides, e.g., La₂₋ₓBaₓCuO_{4-y}, La₂₋ₓSrₓCuO_{4-y}, Ba₂YCu₃O_{9-y}, etc. exhibit superconductivity. It has been discovered that a europium-barium-copper oxide compound in which the europium, barium and copper are in a 1-2-3 ratio, that is, EuBa₂Cu₃Oₓ, exhibits super-conductivity with a transition temperature at approximately 85°K. It is desirable to provide such oxides in forms, e.g., wires or thin films, that permit practical utilization of their superconductive property.

In the past such superconducting oxides were prepared by mixing the individual metal oxide particles to a powdered mixture, forming said mixture into a desired shape, especially into a wire or a ribbon, and sintering and annealing said shaped body in a controlled atmosphere. An essential disadvantage of these superconductive oxide products resides, however, in the mechanical properties thereof, especially in their extremely high brittleness and hardness which considerably impede processing and forming and, thus, are an obstacle to a universal application. In the sintering process and especially in the subsequent cooling microcracks come into existence which, during application, hinder the current passage in a similar way as in the case of inhomogeneous areas in the sintered body, and which lead, due to the increased electrical resistance during operation, to a local heating beyond the critical temperature T.

In a portion of non-prepublished EP-A-0 283 024 based on JP Patent Application 67 647/87 there is disclosed a method for manufacturing a superconductor containing a ceramic superconductive oxide. In this method the metal elements of the superconductive oxides will be melted to an alloy and this alloy will be formed to a fine wire of about 100 µm diameter or to a thin ribbon of about 100 µm thickness by passing through a fine hole or nozzle. For yielding an amorphous structure the wire or ribbon will be injected into a liquid cooling medium. Then, the rapidly solidified amorphous wire or ribbon is oxidized in a furnace for a time period of 2 hours at a high temperature of more than 1000 °C in a controlled oxigen atmosphere in order to obtain a superconductive conductor containing a ceramics superconductive material.

Further, in the non-prepublished EP-A-0 282 839 there is disclosed the preparation of a film of superconductive oxides by vapour deposition processes in which multiple metal sources are used. The pure metal vapours of each of these sources travel to a heated substrate which is exposed to an oxygen ambient for forming a metal oxide film of 1000 Å to 1 µm thickness on the substrate. Afterwards this film will be annealed at a high temperature of about 900 °C in an oxygen atmosphere for obtaining superconductive properties.

Further in a portion of the non-prepublished EP-A-0 282 286 based on JP-A-56 856/87 there is disclosed a method for producing a compound superconductive silver wire containing a predetermined amount of superconductive oxides in the silver matrix. In said method a melted silver alloy containing 70 to 90 wt.% silver and the elements that form a superconductive oxide will be formed to a wire or ribbon by preferably swaging, wire drawing or rolling. The prepared silver alloy wire is then heated for a predetermined time period at a temperature between 500 and 900 °C in an oxidizing atmosphere to form perovskite-type superconducting oxides in the silver matrix.

According to a first aspect of the invention a method for preparing superconductive oxides is defined in claim 1.

According to a second aspect of the invention a method for preparing superconductive oxide-metal composites is defined in claim 2.

Examples of suitable oxides are described in the following references, hereby incorporated by reference and made part of this application: Chu et al. (1987) Phys. Rev. Lett. 58(4) 405-07; Cava et al. (1987) Phys. Rev. Lett. 58(4) 408-10; Wu et al. (1987) "Superconductivity at 93K in a New Mixed Phase Y-Ba-Cu-O Compound System at Ambient Pressure" (submitted for publication, copy attached); Hor et al. (1987) "High Pressure Study of the New Y-Ba-Cu-O Superconducting Compound System" (submitted for publication, copy attached); Tarascon et al. (1987) "Superconductivity at 90K in a Multi-Phase Oxide of Y-Ba-Cu" (submitted for publication, copy attached); Gleick, "Superconductivity: A New Era of Discovery for Electricity," N.Y. Times, Mar. 10, 1987; Tarascon et al. (1987) Science 235: 1373-76. They include, e.g. oxides of La, Ba, and Cu; La, Sr, and Cu; Lu, Ba, and Cu; Lu, Sr, and Cu; and Y, Ba, and Cu. The invention is of course applicable to any superconducting oxide. A europium-barium-copper oxide has been found to be particularly preferred, namely EuBa₂Cu₃Oₓ. This present invention encompasses other compounds including europium.

The invention is hereinafter more particularly described by way of example only with reference to the following examples:-

### Example 1

A superconducting oxide of La, Ba, and Cu is prepared as follows.

Pure La, Ba, and Cu (73.3 wt.% La, 8.1 wt.% Ba, and 18.6 wt.% Cu) are melted under vacuum in an induction melting furnace in a melt spinning apparatus. The liquid alloy is heated to approximately 800°C, and then melt spun to produce a ribbon of the alloy.

The alloy ribbon is oxidized by heating at a constant temperature of 450°C in flowing pure oxygen gas until it is almost completely oxidized. The temperature is then raised to 1000°C and held there until the sample weight is approximately constant and the oxide is homogeneous with respect to composition. The temperature is then reduced to 490°C and maintained at this temperature for approximately 18h. The temperature is then reduced to room temperature.

### Example 2

A superconducting oxide-metal composite, in which the oxide phase is an oxide of La, Ba, and Cu, and the metallic phase is a noble metal such as Ag, is prepared following the procedure described in Example 1 except that Ag metal is melted together with La, Ba, and Cu to form the alloy, the initial oxidation step is at 400°C, and the maximum oxidation temperature is less than the melting point of Ag metal (960°C). During oxidation Ag is not oxidized, but rather precipitates out as a separate phase of substantially pure Ag. The metal phase, by being intimately mixed with the oxide phase, acts as a "skeleton" in the composite, resulting in improved ductility and strength.

### Example 3

A superconducting oxide-metal composite is prepared as in Example 2 except that the noble metal is excess Cu, rather than Ag metal. During oxidation, the temperature, oxygen partial pressure, and reaction time are selected to achieve the oxide stoichiometry required for superconductivity without oxidizing the excess Cu metal to Cu₂O and/or CuO. Thus, the final composite consists of a superconducting La-Ba-Cu oxide phase and a substantially pure Cu metallic phase.

### Example 4

The alloy ribbon prepared in Example 1, 2, or 3 can be formed into a shape, e.g., a ring or coil, prior to oxidation and then oxidized to provide a superconducting oxide or oxide-metal composite in the desired shape.

### Example 5

A superconducting oxide or oxide-metal composite is prepared as in Examples 1, 2, or 3 but in the form of a wire by providing the alloy initially as a hot isostatically pressed compact of a rapidly solidified powder, ground-up rapidly solidified ribbon, or cast billet, and then forming it into a wire by wire drawing. The wire is then shaped by winding it around a metallic core and oxidized to prepare superconducting magnets. The wire can also be oxidized prior to shaping.

### Example 6

The alloy prepared in Examples 1, 2, or 3 is prepared as a rapidly solidified powder, rather than as a ribbon, and then hot isostatically pressed to form a useful shape, e.g., a ring. The shaped article is then oxidized to form a superconducting oxide or oxide-metal composite article.

### Example 7

A superconducting oxide or oxide-metal composite is prepared as in Example 1, 2, or 3 except that the alloy is prepared by melting, then atomizing the liquid alloy using inert gas atomization to form a powder. The alloy powder is coextruded with a billet of a metal or metal alloy to yield a composite wire, rod, or tube. The coextruded product consists of a metal core coated with the alloy. The tube may be coated on the inside or outside surface, or both. The coating is then oxidized to form the superconducting oxide or oxide metal composite. In the case of the superconducting oxide-metal composites, the metal or metal alloy substrate can form a metallurgical bond with the noble metal phase of the composite, thereby promoting adhesion of the coating.

### Example 8

An alloy coating is prepared by running a metal or metal alloy wire through a bath of the molten alloy to form the coating. The hot dipping process is carried out in vacuo or under an inert atmosphere to avoid premature oxidation of the alloy. The coating is then oxidized to form the superconductive oxide or oxide-metal composite as in Examples 1, 2, or 3.

### Example 9

An alloy is prepared as in Examples 1, 2, or 3 but in the form of a coating on a substrate by spray deposition, sputtering, or plasma spraying. Oxidation produces a superconductive oxide or oxide-metal composite coating.

### Example 10

A thin film of the alloy described in Examples 1, 2, or 3 is deposited by, e.g., chemical vapour deposition, vacuum evaporation, sputtering, molecular beam epitaxy, ion beam mixing, or ion implantation, on a metallic, insulating, or semiconducting substrate. The thin film is then oxidized to form a thin film superconducting oxide or metal-oxide composite. This procedure is particularly useful in integrated circuit fabrication, and can be used to produce, e.g., Josephson junction devices.

European Patent Application 0 283 024 in the name of Sumitomo Electric Industries Limited has been drawn to our attention. This Sumitomo application designates DE, FR and GB, and was published on 21 September 1988, which is after the filing date of this current application, and claims priority from Japanese Patent Applications JP 67647/87 filed on 20 March 1987 and JP 81817/87 filed on 2 April 1987.

JP 67647/87 which was filed before the priority date of this present application describes a method of manufacturing a superconductive conductor containing a ceramics superconductive material generally expressed by a formula AaBbCc, where A represents at least one element selected from groups IIa and IIIa of the periodic table, B represents at least one element selected from groups Ib, IIb and IIIb of the periodic table, and C represents at least one element selected from oxygen, carbon, nitrogen, fluorine and sulphur said method comprising: a step of melting said AaBb and injecting the same into a cooling medium through a hole to cool and solidify the same; and a step of heating the same in an atmosphere containing said C.

Also disclosed is heating of La_{1.66}Sr_{0.34}Cu in a crucible to prepare a tape-like body of 30µm thickness and 60mm width by the so-called roll quench method. This substance is then heated in a furnace of 1000°C under oxygen partial pressure of 200 Torr for two hours, to obtain a superconductive conductor.

## Claims

1. A method of preparing a superconducting oxide,
characterized by
- combining the metallic elements of said oxide to form an alloy,
- forming said alloy into a desired shape, and
- oxidizing the formed alloy in an oxidizing step at a first temperature in oxygen or in an oxygen containing atmosphere, raising the temperature to a second temperature higher than the first temperature to form the superconducting oxide phase in a second heating step at that second temperature until the weight of the sample is constant.

2. A method of preparing a superconducting oxide metal composite,
characterized by
- combining the metallic elements of said oxide and a noble metal to form an alloy;
- forming said alloy into a desired shape, and
- oxidizing the formed alloy in an oxidizing step at a first temperature in oxygen or in an oxygen containing atmosphere, raising the temperature to a second temperature higher than the first temperature and lower than the melting temperature of the noble metal to form the superconducting oxide phase intimately mixed with the noble metal phase in a second heating step at that second temperature until the weight of the sample is constant.

3. Method according to claim 2,
characterized in that
said noble metal comprises a stoichiometric excess of one of said metallic elements of said oxide, preferably Cu.

4. Method according to any of the claims 1 to 3,
characterized in that
said alloy is formed by melting said metallic elements together, followed by a rapid solidification processing.

5. Method according to claim 4,
characterized in that
said rapid solidification processing comprises melt spinning or inert gas atomisation.

6. Method according to claim 5,
characterized in that
the powder prepared by said inert gas atomisation is coextruded with a metal billet to yield a composite wire, rod or tube.

7. Method according to any of the claims 1 to 3,
characterized in that
said alloy is formed by melting said metallic elements together, followed by a casting process.

8. Method according to any of the claims 1 to 7,
characterized in that
said alloy is formed into said shape of preferably a wire, ribbon, sheet, rod or ring, by wire drawing, extrusion, coextrusion, hot isostatic pressing or rolling.

9. Method according to claim 8,
characterized in that
the wire is wrapped around a metallic core in the preparation of a superconducting magnet.

10. Method according to any of the claims 1 to 3,
characterized in that
said alloy is formed into a thin film by chemical vapour deposition, vacuum evaporation, spattering, molecular beam epitaxy, ion-beam mixing or ion implantation.

11. Method according to any of the claims 1 to 10,
characterized in that
said metallic elements are chosen from the group consisting of Lu, La, Ba, Cu, Y and Sr.

12. Method according to claim 11,
characterized in that
said metallic elements comprise La, Ba and Cu; or La, Sr and Cu; or Y, Ba and Cu.

13. Method according to any of claims 1 to 12,
characterized in that
said metallic elements comprise Lu, Ba and Cu; or Lu, Sr and Cu; or Eu, Ba and Cu, preferably in a 1-2-3-ratio.

14. Method according to any of claims 1 to 13,
characterized in that
- the metallic elements are melted under vacuum to an alloy,
- the liquid alloy is heated to approximately 800 °C and then formed,
- the formed alloy is oxidized by heating at a constant temperature of 400 to 450 °C in flowing oxygen gas until it is almost completely oxidized and
- the temperature is then raised to no greater than 1000 °C or in the case of the presence of noble metal to a temperature less than the melting point of the noble metal, said raised temperature is held until the sample weight is approximately constant and the superconducting oxide is homogeneous with respect to the composition, and
- the temperature is then reduced to an intermediate value for a predetermined time and then reduced to room temperature.

## Patentansprüche

1. Verfahren zum Herstellen eines supraleitenden Oxids,
**gekennzeichnet** durch
- Kombinieren der metallischen Elemente dieses Oxids zur Bildung einer Legierung,
- Formen dieser Legierung in eine gewünschte Form und
- Oxidieren der geformten Legierung in einer Oxidierstufe bei einer ersten Temperatur in Sauerstoff oder in einer sauerstoffhaltigen Atmosphäre, Erhöhen der Temperatur auf eine gegenüber der ersten Temperatur höhere Temperatur zur Bildung der supraleitenden Oxidphase in einer zweiten Beheizungsstufe bei dieser zweiten Temperatur bis zur Gewichtskonstanz der Probe.

2. Verfahren zum Herstellen eines supraleitenden Oxid-Metall-Verbundwerkstoffs,
gekennzeichnet durch
- Kombinieren der metallischen Elemente des Oxids und eines Edelmetalls zur Bildung der Legierung,
- Formen dieser Legierung in eine gewünschte Form,
- Oxidieren der geformten Legierung in einer Oxidierstufe bei einer ersten Temperatur in Sauerstoff oder einer sauerstoffhaltigen Atmosphäre, Erhöhen der Temperatur auf eine zweite Temperatur, die höher als die erste Temperatur und niedriger als die Schmelztemperatur des Edelmetalls ist, zur Bildung der mit der Edelmetallphase innig gemischten supraleitenden Oxidphase in einer zweiten Beheizungsstufe bei dieser zweiten Temperatur bis zur Gewichtskonstanz der Probe.

3. Verfahren nach Anspruch 2,
dadurch gekennzeichnet, daß
das Edelmetall eines der metallischen Elemente des Oxids, vorzugsweise Cu, in stöchiometrischem Überschuß ist.

4. Verfahren nach einem der Ansprüche 1 bis 3,
dadurch gekennzeichnet, daß
die Legierung durch gemeinsames Schmelzen der metallischen Elemente gebildet wird, an das sich ein Schnell-Verfestigungs-Prozeß anschließt.

5. Verfahren nach Anspruch 4,
dadurch gekennzeichnet, daß
der Schnell-Verfestigungs-Prozeß das Schmelzspinnen oder die Inertgas-Atomisation umfaßt.

6. Verfahren nach Anspruch 5,
dadurch gekennzeichnet, daß
das durch Inertgas-Atomisation gebildete Pulver mit einem Metallstrang zum Erhalt eines Drahtes, eines Stabes oder eines Rohres aus Verbundwerkstoff extrudiert wird.

7. Verfahren nach einem der Ansprüche 1 bis 3,
dadurch gekennzeichnet, daß
die Legierung durch gemeinsames Schmelzen der metallischen Elemente gebildet wird, an das sich ein Gießprozeß anschließt.

8. Verfahren nach einem der Ansprüche 1 bis 7,
dadurch gekennzeichnet, daß
die Legierung in die gewünschte Form, vorzugsweise eines Drahtes, eines Bandes, einer Folie, eines Stabes oder eines Rings, durch Drahtziehen, Extrudieren, Koextrudieren, isostatisches Heißpressen oder Walzen gebracht wird.

9. Verfahren nach Anspruch 8,
dadurch gekennzeichnet, daß
der Draht um einen Metallkern gewickelt wird zur Herstellung eines supraleitenden Magneten.

10. Verfahren nach einem der Ansprüche 1 bis 3,
dadurch gekennzeichnet, daß
die Legierung zu einem dünnen Film durch chemische Dampfablagerung, Vakuum-Verdampfung, Aufsprühen, Molekularstrahl-Epitaxie, Ionenstrahlmischen oder Ionenimplantation geformt wird.

11. Verfahren nach einem der Ansprüche 1 bis 10,
dadurch gekennzeichnet, daß
die metallischen Elemente aus der die Elemente Lu, La, Ba, Cu, Y und Sr enthaltenden Gruppe ausgewählt sind.

12. Verfahren nach Anspruch 11,
dadurch gekennzeichnet, daß
die metallischen Elemente La, Ba und Cu, oder La, Sr und Cu, oder Y, Ba und Cu enthalten.

13. Verfahren nach einem der Ansprüche 1 bis 12,
dadurch gekennzeichnet, daß
die metallischen Elemente Lu, Ba und Cu, oder Lu, Sr und Cu, oder Eu, Ba und Cu, vorzugsweise in einem 1-2-3-Verhältnis enthalten.

14. Verfahren nach einem der Ansprüche 1 bis 13,
dadurch gekennzeichnet, daß
- die metallischen Elemente im Vakuum zu einer Legierung geschmolzen werden,
- die schmelzflüssige Legierung auf etwa 800 °C erwärmt und dann geformt wird,
- die geformte Legierung durch Erwärmen bei einer konstanten Temperatur von 400 bis 450 °C in einem Sauerstoffgasstrom bis zur weitgehend vollständigen Oxidation oxidiert wird und
- die Temperatur danach auf nicht über 1000 °C oder bei Gegenwart des Edelmetalls auf eine Temperatur unter dem Schmelzpunkt des Edelmetalls erhöht wird, diese erhöhte Temperatur beibehalten wird bis das Probengewicht weitestgehend konstant ist und das supraleitende Oxid mit Bezug auf die Zusammensetzung homogen vorliegt und
- die Temperatur danach für eine vorbestimmte Zeitspanne auf eine mittlere Temperatur und anschließend auf Raumtemperatur reduziert wird.

## Revendications

1. Méthode de préparation d'un oxyde supraconducteur, caractérisée par
- la combinaison des éléments métalliques dudit oxyde afin de former un alliage,
- le modelage dudit alliage pour donner une forme voulue, et
- l'oxydation de l'alliage modelé au cours d'une étape d'oxydation à une première température, dans de l'oxygène ou dans une atmosphère contenant de l'oxygène, en augmentant la température jusqu'à atteindre une seconde température, supérieure à la première température, afin de former la phase d'oxyde supraconducteur au cours d'une seconde étape de chauffage à cette seconde température, jusqu'à ce que le poids de l'échantillon soit constant.

2. Méthode de préparation d'un composite oxyde-métal supraconducteur, caractérisée par
- la combinaison des éléments métalliques dudit oxyde avec un métal noble afin de former un alliage,
- le modelage dudit alliage pour donner une forme voulue, et
- l'oxydation de l'alliage modelé au cours d'une étape d'oxydation à une première température, dans de l'oxygène ou dans une atmosphère contenant de l'oxygène, en augmentant la température jusqu'à une seconde température, supérieure à la première température et inférieure à la température de fusion du métal noble, afin de former la phase d'oxyde supraconducteur intimement mélangée à la phase du métal noble, au cours d'une seconde étape de chauffage à cette seconde température, jusqu'à ce que le poids de l'échantillon soit constant.

3. Méthode selon la revendication 2, caractérisée en ce que ledit métal noble comporte un excédent stoechiométrique de l'un desdits éléments métalliques dudit oxyde, de préférence Cu.

4. Méthode selon l'une quelconque des revendications 1 à 3, caractérisée en ce que ledit alliage est formé par la fusion desdits éléments métalliques ensemble, suivie d'un procédé de solidification rapide.

5. Méthode selon la revendication 4, caractérisée en ce que ledit procédé de solidification rapide comporte de la filature en fusion ou de l'atomisation en atmosphère inerte.

6. Méthode selon la revendication 5, caractérisée en ce que la poudre préparée à partir de ladite atomisation en atmosphère inerte est coextrudée avec une billette métallique afin de produire un fil, une tige ou un tube composite.

7. Méthode selon l'une quelconque des revendications 1 à 3, caractérisée en ce que ledit alliage est formé par le mélange desdits éléments métalliques ensemble, suivi par un cycle de coulée.

8. Méthode selon l'une quelconque des revendications 1 à 7, caractérisée en ce que ledit alliage est modelé pour donner ladite forme, de préférence d'un fil, d'un ruban, d'une feuille, d'une tige ou d'une bague, par étirage, extrusion, coextrusion, estampage ou laminage à chaud isostatique.

9. Méthode selon la revendication 8, caractérisée en ce que le fil est enroulé autour d'un noyau métallique au cours de la préparation d'un aimant supraconducteur.

10. Méthode selon l'une quelconque des revendications 1 à 3, caractérisée en ce que ledit alliage est modelé pour donner un film mince par dépôt chimique en phase vapeur, métallisation sous vide, pulvérisation, épitaxie par faisceau moléculaire, mélange par faisceau ionique ou implantation ionique.

11. Méthode selon l'une quelconque des revendications 1 à 10, caractérisée en ce que lesdits éléments métalliques sont choisis parmi le groupe constitué par Lu, La, Ba, Cu, Y et Sr.

12. Méthode selon la revendication 11, caractérisée en ce que lesdits éléments métalliques comprennent La, Ba et Cu; ou La, Sr et Cu; ou Y, Ba et Cu.

13. Méthode selon l'une quelconque des revendications 1 à 12, caractérisée en ce que lesdits éléments métalliques comprennent Lu, Ba et Cu; ou Lu, Sr et Cu; ou Eu, Ba et Cu, de préférence dans une proportion de 1-2-3.

14. Méthode selon l'une quelconque des revendications 1 à 13, caractérisée en ce que
- les éléments métalliques sont fondus sous vide pour donner un alliage,
- l'alliage liquide est chauffé à approximativement 800 °C puis ensuite modelé,
- l'alliage modelé est oxydé en chauffant à une température constante de 400 à 450 °C dans un flux d'oxygène jusqu'à ce qu'il soit presque complètement oxydé, et
- la température est ensuite élevée sans aller plus haut que 1000 °C ou, dans le cas de la présence d'un métal noble, à une température inférieure au point de fusion du métal noble, ladite température élevée étant maintenue jusqu'à ce que le poids de l'échantillon soit approximativement constant et que l'oxyde supraconducteur soit homogène en ce qui concerne la composition, et
- la température est ensuite réduite à une valeur intermédiaire pendant une durée prédéterminée puis ensuite réduite jusqu'à la température ambiante.
